# EUROPEAN PATENT APPLICATION

(11) **EP 4 564 596 A1**
(43) Date of publication of application: **04.06.2025**
(21) Application number: 24213279.3
(22) Date of filing: 15.11.2024
(51) Int. Cl.: H01Q 1/22, H01Q 1/38, H01Q 1/44, H01Q 1/48, H01Q 9/42, H01Q 19/10

(54) **ELECTRONIC DEVICE**

(30) Priority: 29.11.2023 JP 2023201713
(71) Applicant: CASIO COMPUTER CO., LTD., Tokyo 151-8543 (JP)
(72) Inventor: Matsue, Takeshi, Hamura-shi, Tokyo, 205-8555 (JP); Seo, Munetaka, Hamura-shi, Tokyo, 205-8555 (JP)
(74) Representative: Grünecker Patent- und Rechtsanwälte PartG mbB

(57) **Abstract**

An electronic device (1) includes: a flat plate-shaped circuit board (10); an antenna (40) that is provided on the circuit board and has an antenna pattern (41) extending in a first direction parallel to a board surface of the circuit board; and a frame (20). At least a portion of the frame is electrically connected to the antenna via a ground-contacting surface of the circuit board. The frame has a main frame (21) and a side frame. (22) At least a portion of the main frame overlaps the circuit board when seen from a direction orthogonal to the board surface, and the side frame is electrically conductive, is connected to the main frame, and extends in a direction substantially orthogonal to the board surface. The electronic device performs transmission and/or reception of radio waves having a desired wavelength, using a composite antenna (A) of the antenna and the side frame.

## Description

### TECHNICAL FIELD

The present invention pertains to an electronic device.

### DESCRIPTION OF RELATED ART

Heretofore, there is a technique for disposing, within a portable electronic device, an antenna for communicating outside of the electronic device, as in Japanese Patent Application No. 2008-241396, for example.

However, due to design constraints, a region in which an antenna can be disposed is often limited in a small electronic device. Accordingly, there are problems in that it is difficult to provide an ideal antenna such as one that can realize a desired antenna sensitivity, and antenna sensitivity is more likely to be lower.

### SUMMARY OF THE INVENTION

An electronic device according to the present disclosure includes:
a flat plate-shaped circuit board;
an antenna that is provided on the circuit board and has an antenna pattern that extends in a first direction parallel to a board surface of the circuit board; and
a frame at least a portion of which is electrically connected to the antenna via a ground-contacting surface of the circuit board,
wherein the frame has a main frame and a side frame,
wherein at least a portion of the main frame overlaps the circuit board when seen from a direction that is orthogonal to the board surface,
wherein the side frame is electrically conductive, is connected to the main frame, and extends in a direction that is substantially orthogonal to the board surface at a side of the circuit board,
wherein the electronic device is configured to perform at least one of transmission and reception of radio waves having a desired wavelength, using a composite antenna that has the antenna and the side frame.

### BRIEF DESCRIPTION OF DRAWINGS

FIG. 1 is a perspective view that illustrates an appearance of an electronic timepiece;
FIG. 2 is a perspective view of a module;
FIG. 3 is a view that illustrates the module in a state where a cover and a display have been removed;
FIG. 4 is a view that illustrates a cross-section of the module at a position that goes through a recess;
FIG. 5 is a plan view in which a circuit board and a frame are seen from a -Z direction;
FIG. 6 is a view that illustrates a positional relationship between an antenna pattern and a side frame;
FIG. 7 is a perspective view of the surroundings of an antenna, from among the circuit board and the frame;
FIG. 8 shows a result of numerical calculations of a gain distribution for a composite antenna according to the present embodiment;
FIG. 9 shows a result of numerical calculations of a gain distribution for the composite antenna according to the present embodiment;
FIG. 10 shows a result of numerical calculations of a gain distribution for an antenna in an electronic timepiece according to a comparative example that lacks the composite antenna; and
FIG. 11 shows a result of numerical calculations of a gain distribution for the antenna in the electronic timepiece according to the comparative example that lacks the composite antenna.

### DETAILED DESCRIPTION

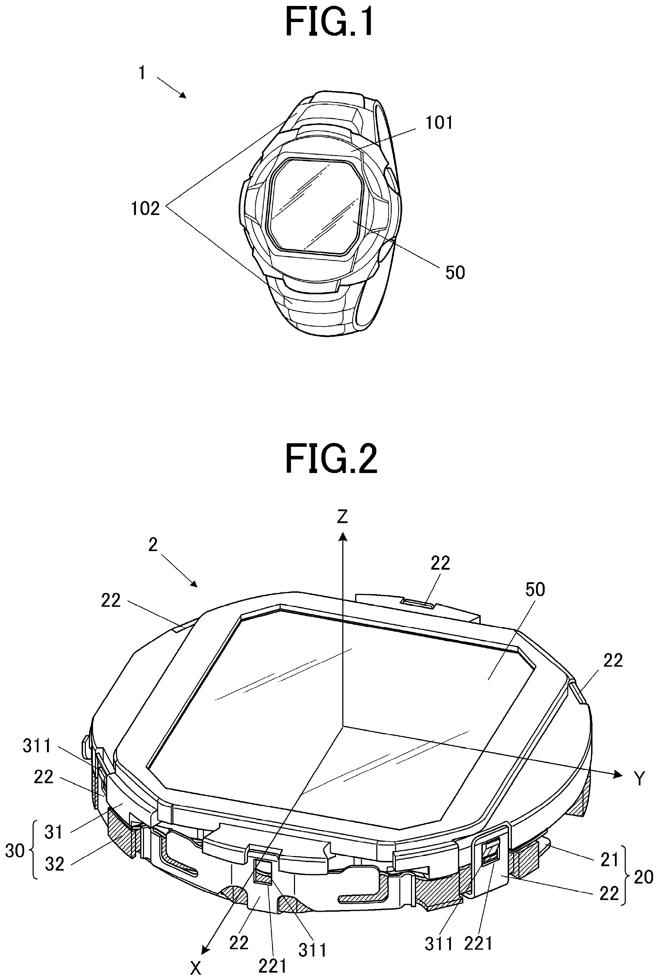

Embodiments of the present disclosure are described below on the basis of the drawings. FIG. 1 is a perspective view that illustrates an appearance of an electronic timepiece 1. The electronic timepiece 1 (an electronic device) is provided with a case 101 and two bands 102 that are attached to the case 101. A module 2 (refer to FIG. 2) that has a display 50 and the like is stored inside the case 101. The electronic timepiece 1 is a wristwatch that a user wears on their wrist by the bands 102 being wound therearound. Of the case 101, the display surface side of the display 50 has transparent windshield glass, and it is possible to visually recognize what is displayed on the display 50 through the windshield glass. The electronic timepiece 1 displays information such as a time and date on the display 50.

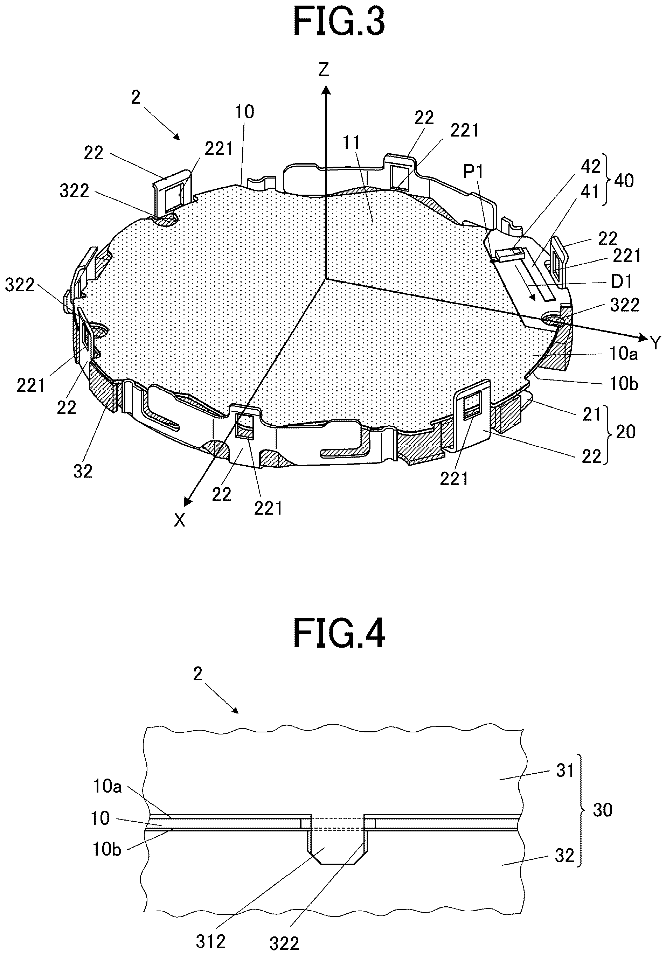

FIG. 2 is a perspective view of the module 2. The module 2 is provided with the display 50, a flat plate-shaped circuit board 10 (refer to FIG. 3), a housing 30 that accommodates the circuit board 10, and a frame 20 that restricts the housing 30 from outside. In a gap between the module 2 and the case 101, an inner frame that is made of resin or the like and that fills the gap may be provided. Directions are represented below using an XYZ Cartesian coordinate system having as an origin the center of the display surface of the display 50. The normal direction of the display surface of the display 50 is set to the Z axis (+Z direction), and two axes parallel to the display surface are set to the X axis and the Y axis. Below, an orientation in the XY plane is written as an "N o'clock direction" using directions of each hour (1 o'clock through 12 o'clock) for an analog timepiece when faced to the display 50. The 3 o'clock direction is set to the +X direction and the 12 o'clock direction is set to the +Y direction. In addition, for any member, the +Z direction side of that member is written as the upper side and the -Z direction side thereof is written as the lower side.

The display 50 has a liquid-crystal display panel and a drive circuit that drives the liquid-crystal display panel. The display 50 uses the liquid-crystal display panel to digitally display information by the drive circuit driving the liquid-crystal display panel in accordance with a control signal that is supplied from the circuit board 10. Note that the display 50 may be an analog display that displays a point in time or the like by a plurality of hands rotationally operating on a dial.

The housing 30 has a support 32 and a cover 31 that sandwich the circuit board 10 from above and below. The material of the cover 31 and the support 32 is resin, for example. FIG. 3 is a view that illustrates the module 2 in a state in which the cover 31 and the display 50 have been removed. In FIGs. 2 and 3, the support 32 is colored using hatched lines in order to make it easier to differentiate the cover 31, the support 32, and the frame 20. Below, the upper surface of the circuit board 10 is referred to as a first surface 10a, and the lower surface thereof is referred to as a second surface 10b. The cover 31 supports the first surface 10a of the circuit board 10 from above and the support 32 supports the second surface 10b of the circuit board 10 from below.

As illustrated in FIGs. 2 and 3, the exterior of the module 2 - in other words, the exterior of the circuit board 10, the cover 31, the support 32, and the frame 20 - has fine unevenness but is mostly circular when seen from a direction orthogonal to a board surface (the first surface 10a or the second surface 10b) of the circuit board 10, in other words, from the Z direction. In addition, the cover 31 and the support 32 are substantially cylindrical. However, the external shape of the module 2 is not limited to being circular, and may be rectangular or the like.

As illustrated in FIG. 2, a substantially rectangular frame, which corresponds to the external shape of the display 50 that is substantially rectangular, is provided on the upper surface of the cover 31. The display 50 is attached to the top surface of the cover 31, fitting to this frame. An opening (not illustrated) that penetrates the cover 31 is provided at a portion of the cover 31 that overlaps with the display 50 when seen from the Z direction. The display 50 is connected to the circuit board 10 by a signal line, a power supply line, or the like that goes through this opening.

Various electronic components and electronic circuits for controlling operation by the display 50 are provided on surfaces of the circuit board 10 illustrated in FIG. 3, mainly on the first surface 10a. In addition, a conductor that configures a ground-contacting surface 11, which is set as a ground potential, is formed on the surface of the circuit board 10. For the convenience of the description, the ground-contacting surface 11 is depicted plain in FIG. 3, but the ground-contacting surface 11 in practice is patterned in accordance with wiring or the arrangement of electronic components and electronic circuits. The ground-contacting surface 11 is provided on each of the first surface 10a and the second surface 10b, and is electrically connected via a through via that penetrates the circuit board 10. Accordingly, the ground-contacting surface 11 extends over both of the first surface 10a and the second surface 10b.

An antenna 40 for wirelessly communicating with an external device is provided at the periphery at approximately the 11 o'clock direction, of the first surface 10a of the circuit board 10. In a case where, for example, the distance (the radius in the present embodiment) from the center (origin) of the circuit board 10 seen from the Z direction to the edge thereof is regarded as d, the periphery of the circuit board 10 is a region in which the distance from the center is greater than 0.8d. In the present embodiment, wireless communication means Bluetooth (registered trademark). The antenna 40 is designed to be able to transmit and receive radio waves of 2.4 to 2.48 GHz, which is a frequency band used in Bluetooth. The wavelength of a radio wave in this frequency band is denoted by λ below. λ is roughly 120 to 124 mm, and λ/4 is roughly 30 to 31 mm.

The antenna 40 has an antenna pattern 41 that extends in a first direction D1 (a prescribed direction) that is parallel to the first surface 10a of the circuit board 10, and an antenna chip 42 that is connected to the antenna pattern 41. The first direction D1 is orthogonal to the 11 o'clock direction. In other words, the first direction D1 is at +30° when the X axis is defined as an azimuth angle that is set to 0°. However, the first direction D1 is not limited to this, and can be adjusted, as appropriate, in accordance with a mounting position for another component.

The antenna pattern 41 is a linear (rod-shaped) metal conductor that is provided on the first surface 10a. The antenna pattern 41 configures a ground-contacting monopole antenna that uses the ground-contacting surface 11 described above. The antenna chip 42 is an electronic component for achieving a wavelength shortening effect in a used frequency band, for example. By setting the length of the antenna pattern 41 to be shorter than λ/4 (for example, after setting the length to approximately λ/8) and providing the antenna chip 42 that achieves the wavelength shortening effect, it is possible to transmit and receive radio waves of the Bluetooth frequency band. In a case such as where wavelength shortening using the antenna chip 42 is unnecessary, the antenna chip 42 may be omitted.

The antenna chip 42 is electrically connected to the ground-contacting surface 11 via an RF matching circuit (not illustrated) or the like. The position at which the antenna 40 is connected to the ground-contacting surface 11 is referred to as a ground contact point P1 hereinbelow. In addition, the ground contact point P1 is near a power supply point at which a transmission signal is inputted to the antenna 40 or at which a reception signal is outputted from the antenna 40, and the ground contact point P1 is treated as being at substantially the same position as the power supply point.

As illustrated in FIG. 3, the support 32 supports substantially the entirety of the second surface 10b of the circuit board 10. A portion of the periphery on the top surface of the support 32 is exposed and is not covered by the circuit board 10. Three recesses 322 are provided at the exposed area.

FIG. 4 is a view that illustrates a cross-section of the module 2 at a position that goes through a recess 322. As illustrated in FIG. 4, the cover 31 has, on the lower surface thereof, a protrusion 312 that extends in the -Z direction toward the support 32. The cover 31 has three protrusions 312, and the support 32 has, at positions corresponding to these three protrusions 312, three recesses 322 that respectively fit with the protrusions 312. The protrusions 312 and the recesses 322 fit at the three positions, whereby the cover 31 and the support 32 are joined in a predefined positional relationship, and do not deviate from each other in the XY planar direction. Note that protrusions that extend in the +Z direction extend toward the cover 31 may be provided on the top surface of the support 32, and recesses may be provided on the cover 31 at positions that correspond to the protrusions.

Back in FIG. 2, the cover 31 covers at least a portion of the first surface 10a of the circuit board 10. Six engaging parts 311 having a protruding shape are providing on the side surface of the cover 31 (cylinder surface connecting the top surface and bottom surface thereof). The engaging parts 311 are provided at respective positions for the 1 o'clock direction, the 3 o'clock direction, the 5 o'clock direction, the 7 o'clock direction, the 9 o'clock direction, and the 11 o'clock direction on the side surface. In other words, the six engaging parts 311 are provided at approximately equal intervals along the outer periphery of the circuit board 10. Approximately equal intervals include equal intervals as well as intervals with the minimum value thereof greater than or equal to 0.9 times the maximum value, for example.

As illustrated in FIGs. 2 and 3, the frame 20 is provided with a main frame 21 that is positioned below the support 32 and comes into contact with the lower surface of the support 32, and a plurality of side frames 22 that are connected to the main frame 21. At the side of the circuit board 10, each of the side frames 22 extends in a direction (+Z direction) that is orthogonal to the first surface 10a. Note that each of the side frames 22 does not necessarily need to be orthogonal to the first surface 10a, and may extend obliquely with respect to a direction that is substantially orthogonal to the first surface 10a. The main frame 21 and the side frames 22 are made of metal that is electrically conductive.

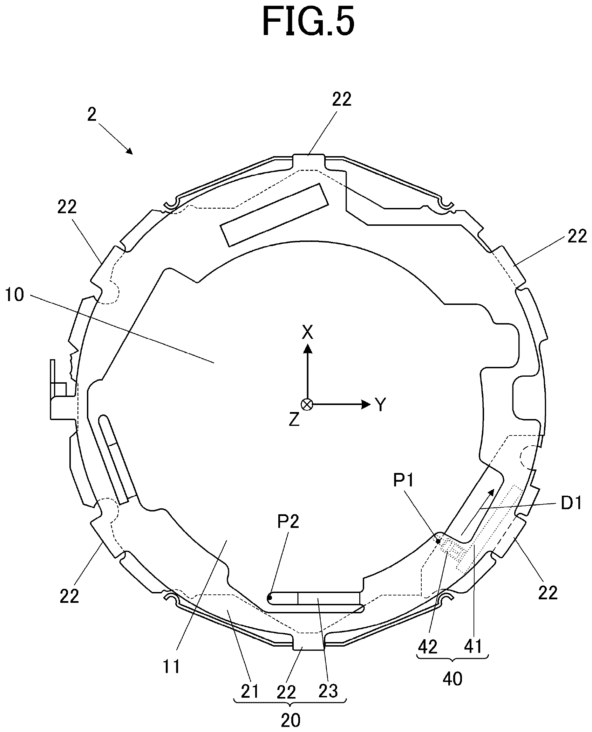

FIG. 5 is a plan view in which the circuit board 10 and the frame 20 are seen from the -Z direction. FIG. 5 is a view that illustrates the positional relationship between the circuit board 10 and the frame 20, omitting the support 32. As illustrated in FIG. 5, at least a portion of the main frame 21 of the frame 20 overlaps with the circuit board 10 when seen from the -Z direction. In detail, the main frame 21 is an annular member having a part that overlaps with the periphery of the circuit board 10 when seen from the -Z direction, and has an opening in the center thereof. However, the shape of the main frame 21 is not limited to that illustrated in FIG. 5, and may be a shape where at least a portion of the main frame 21 overlaps with the circuit board 10 when seen from the -Z direction. The frame 20 has a spatula-shaped connection frame 23 that protrudes from the inner periphery of the main frame 21. The connection frame 23 extends obliquely toward the circuit board 10 from the main frame 21, in other words in a direction that has a +Z directional component, and the tip of the connection frame 23 is in contact with the ground-contacting surface 11 of the second surface 10b of the circuit board 10. The position where the connection frame 23 is in contact with the ground-contacting surface 11 of the circuit board 10, in other words the position where there is an electrical connection therebetween, is referred to as a connection point P2 below. The frame 20 is electrically connected to the antenna 40 via the ground contact point P1 and the connection point P2 on the ground-contacting surface 11 of the circuit board 10.

As illustrated in FIGs. 2 and 3, the frame 20 has the side frames 22 at positions (engaging position) that respectively correspond to the six engaging parts 311 of the cover 31. On each of the side frames 22, an opening 221 is provided at a position that corresponds to each of the engaging parts 311. The engaging parts 311 engage with (hook onto) the openings 221, whereby the positional relationships of the side frames 22 with the cover 31 are secured. The main frame 21 is in contact with the support 32 and the side frames 22 engage with the engaging parts 311 of the cover 31, whereby the frame 20 secures the cover 31 and the support 32 in a state where the cover 31 and the support 32 sandwich the circuit board 10 therebetween. The side frames 22, which are positioned in the 1 o'clock direction, the 5 o'clock direction, the 7 o'clock direction, and the 11 o'clock direction are substantially rectangular. "Substantially rectangular" shapes includes a rectangular shape with chamfered corners, for example. The side frames 22 positioned in the 3 o'clock direction and the 9 o'clock direction each have a portion where the opening 221 is provided, and a portion that extends left and right from the portion with the opening 221 to support the side surface of the support 32. The number of pairs of the engaging parts 311 and the corresponding side frames 22 is not limited to six, and at least three pairs are to be provided in order to stably secure the cover 31 and the support 32. In place of the opening 221, a cut-out shaped by partially cutting the side surface of the side frame 22 may be provided. In this case, the engaging parts 311 have a protruding shape that engages with the cut-out.

From among the six side frames 22, the side frame 22 positioned near the antenna pattern 41 (the side frame 22 positioned in the 11 o'clock direction) functions as an antenna together with the antenna pattern 41. Description is given below regarding, inter alia, the positional relationship between this single side frame 22 and the antenna pattern 41 as well as electrical action by this side frame 22.

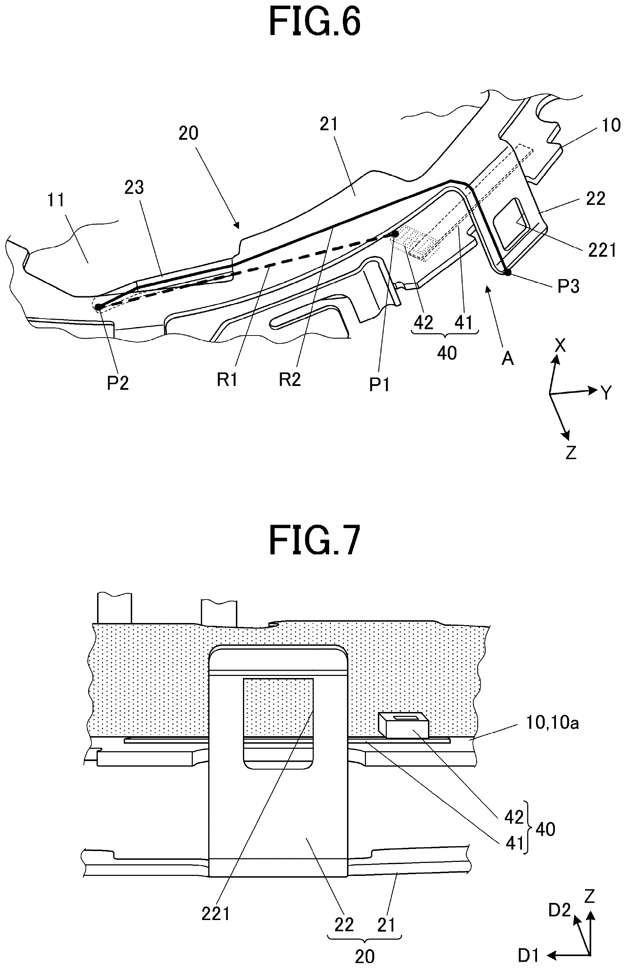

FIG. 6 is a perspective view of the surroundings of the antenna 40 of the circuit board 10 and the frame 20. FIG. 6 is a perspective view in which the circuit board 10 and the frame 20 are seen from below. The side frame 22 is electrically connected to the connection point P2 on the ground-contacting surface 11 of the circuit board 10, via the main frame 21 and the connection frame 23. Accordingly, the side frame 22 is electrically connected to the antenna pattern 41 of the antenna 40 via the ground-contacting surface 11. The side frame 22 configures a ground-contacting monopole antenna that uses the ground-contacting surface 11, similarly to the antenna pattern 41, as described above. Alternatively, it can also be said that the side frame 22 and the antenna pattern 41 configure a dipole antenna. Accordingly, the side frame 22 and the antenna pattern 41 function as two monopole antennas and/or a dipole antenna.

FIG. 7 is a view that illustrates the positional relationship between the antenna pattern 41 and the side frame 22. As illustrated in FIG. 7, the side frame 22 is provided at a position that faces and is orthogonal to (intersects) the antenna pattern 41, seen from a second direction D2 that is orthogonal to the first direction D1 and is parallel to the first surface 10a of the circuit board 10. The angle formed between the antenna pattern 41 and the side frame 22, when seen from the second direction D2, is the angle formed between the first direction D1 in which the antenna pattern 41 extends and the direction in which the side frame 22 extends. In the present specification, the direction of extension of the side frame 22 is the direction of extension of edges (two edges that extend vertically in FIG. 7) that extend toward the tip of the side frame 22 from the connection with the main frame 21 from among the edges that form the exterior of the side frame 22. Accordingly, the side frame 22 and the antenna pattern 41 being orthogonal when seen from the second direction D2 means that the first direction D1 in which the antenna pattern 41 extends is orthogonal to the edges of the side frame 22 that extend vertically in FIG. 7. In addition, another electrical conductor is not provided between this side frame 22 and the antenna pattern 41. It is most desirable for the side frame 22 to intersect the antenna pattern 41 at the center of the antenna pattern 41, when seen from the second direction. However, the side frame 22 sufficiently functions as an antenna even if the side frame 22 is shifted to the left or right from the central position of the antenna pattern 41. When the antenna pattern 41 and the side frame 22 are parallel seen from the second direction D2, in a case where the phase of the amplitude of a current arising at the antenna pattern 41 is opposite to that of a current arising at the side frame 22, the currents cancel out to weaken radiation. In contrast to this, as in the present embodiment, as the antenna pattern 41 and the side frame 22 are arranged to be orthogonal to each other when seen from the second direction D2, the phenomenon of the amplitudes of currents canceling out one another is less likely to arise, and it is thereby possible to effectively improve antenna sensitivity. In addition, the above-described arrangement can ensure gain (sensitivity) for both horizontal polarization and vertical polarization.

Back in FIG. 6, a conductive path that is from the ground contact point P1 on the antenna 40 and reaches the tip P3 of the side frame 22 via the connection point P2 of the circuit board 10 and the connection frame 23, is a length that substantially corresponds to λ/4. In detail, the sum of a first conductive path R1 from the ground contact point P1 to the connection point P2 on the ground-contacting surface 11 of the circuit board 10 and a second conductive path R2 from the connection point P2 to the tip P3 of the side frame 22 via the connection frame 23 and the main frame 21 is a length that substantially corresponds to λ/4. By satisfying such arrangement conditions, the side frame 22 functions as an antenna that can transmit and receive Bluetooth radio waves. Here, the "length that substantially corresponds to λ/4" includes aλ/4 (a < 1; wavelength shortening rate) in a case where the wavelength λ is shortened to a wavelength aλ in accordance with the permittivity of a member in the vicinity of the conductive path. For example, in a case where a wavelength shortening rate a is in the range of 0.67 to 1 (inclusive), the "length that substantially corresponds to λ/4" includes a range that is 0.67λ/4 to λ/4 (inclusive). In addition, the "length that substantially corresponds to λ/4" includes a certain range centered on aλ/4 with the wavelength shortening taken into consideration. The certain range may be 0.8 × aλ/4 to 1.2 × aλ/4 (inclusive), for example. Accordingly, in a case where a wavelength shortening rate a is in the range of 0.67 to 1 (inclusive), the "length that substantially corresponds to λ/4" includes a range that is 0.8 × 0.67λ/4 to 1.2 × λ/4 (inclusive).

Below, a configuration that includes the antenna 40 and the side frame 22 that functions as an antenna and that is used for at least one of transmission and reception of radio waves having a desired wavelength, is referred to as a "composite antenna A" (refer to FIG. 6). The composite antenna A has the antenna 40, a first portion that is from the ground contact point P1 to the connection point P2 of the ground-contacting surface 11 (a portion corresponding to the first conductive path R1), and a second portion that is from the connection point P2 to the tip P3 of the side frame 22 (a portion corresponding to the second conductive path R2) of the side frame 22. From among these, the second portion includes the connection frame 23, a portion of the main frame 21, and the side frame 22. The side frame 22 intersects with the antenna pattern 41 when seen from the second direction D2 and satisfies the arrangement conditions described above, whereby the side frame 22 can suitably function as an antenna and improve the antenna sensitivity of the antenna 40. In other words, it is possible to configure the composite antenna A that has higher antenna sensitivity than the antenna 40 alone.

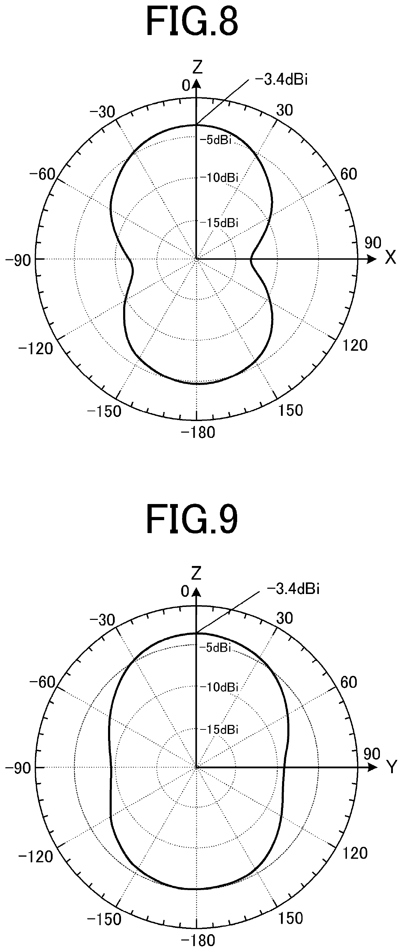

Next, description is given regarding an effect of using the composite antenna A according to the present embodiment to improve antenna sensitivity (antenna gain). FIGs. 8 and 9 show results of numerical calculations of gain distributions for the composite antenna A according to the present embodiment. From among them, FIG. 8 shows a gain distribution in the X-Z plane, and FIG. 9 shows a gain distribution in the Y-Z plane. In addition, FIGs. 8 and 9 show distributions of combined gains of vertical polarization and horizontal polarization. As shown in FIGs. 8 and 9, a gain of -3.4 dBi is obtained in the +Z direction using the electronic timepiece 1 according to the present embodiment.

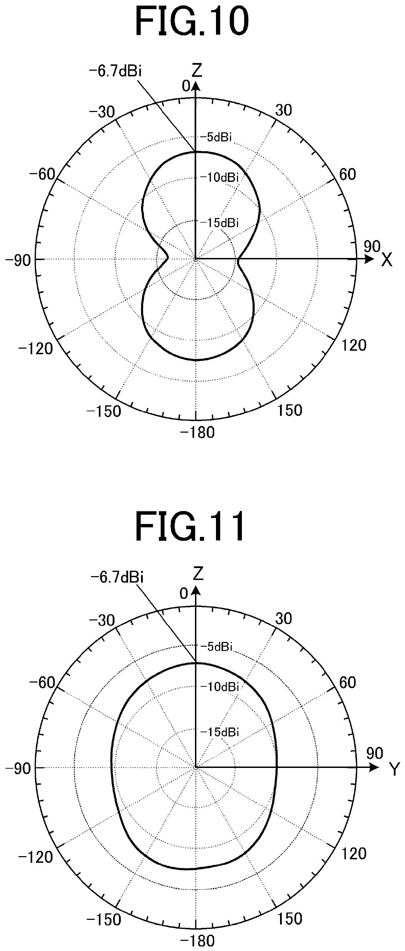

FIGs. 10 and 11 show results of numerical calculations of gain distributions for an antenna in an electronic timepiece according to a comparative example that lacks the composite antenna A. The electronic timepiece 1 according to the comparative example has a configuration resulting from removing, from the electronic timepiece 1 according to the present embodiment, the side frame 22 that is positioned in the 11 o'clock direction and is illustrated in FIGs. 2 and 3 (the side frame 22 that is positioned near the antenna pattern 41). Similarly to FIGs. 8 and 9, FIG. 10 shows a distribution of combined gains of vertical polarization and horizontal polarization in the X-Z plane, and FIG. 11 shows a distribution of combined gains in the Y-Z plane. As shown in FIGs. 10 and 11, the gain in the +Z direction was -6.7 dBi for the electronic timepiece according to the comparative example. Accordingly, comparing FIGs. 8 and 9 with FIGs. 10 and 11, it was confirmed that a gain increase of 3.3 dBi (an increase in sensitivity) was realized by the configuration of the present embodiment with the composite antenna A.

### (Effects)

Conventionally, due to design constraints, a region in which an antenna can be disposed is often limited in a small electronic device. Accordingly, in a conventional electronic device, there have been problems in that it is difficult to provide an ideal antenna such as one that can realize a desired antenna sensitivity and in that antenna sensitivity is more likely to be lower.

In contrast to this, the electronic timepiece 1 according to the present embodiment is provided with the flat plate-shaped circuit board 10, the antenna 40 that is provided on the circuit board 10 and has the antenna pattern 41 that extends in the first direction D1 that is parallel to the board surface of the circuit board 10, and the frame 20. At least a portion of the frame 20 is electrically connected to the antenna 40 via the ground-contacting surface 11 of the circuit board 10. The frame 20 has the main frame 21 and the side frame 22 electrically conductive. At least a portion of the main frame 21 overlaps with the circuit board 10 when seen from the Z direction, and the side frame 22 is connected to the main frame 21 and extends in the +Z direction at the side of the circuit board 10. The electronic timepiece 1 is configured to perform at least one of transmission and reception of radio waves having a desired wavelength, using the composite antenna A that has the antenna 40 and the side frame 22. By virtue of such a configuration, the side frame 22 of the frame 20 can function as an antenna. Accordingly, it is possible to use the side frame 22 that functions as an antenna to improve the antenna sensitivity of the antenna 40, while using the frame 20 to ensure reliability and impact resistance of the module 2. In other words, it is possible to configure the composite antenna A that has higher antenna sensitivity than the antenna 40 alone. In addition, because the side frame 22 functions as an antenna, there is no need to add a new configuration in order to improve antenna sensitivity. Accordingly, it is possible to improve antenna sensitivity without increasing the size or manufacturing cost of the electronic timepiece 1.

In addition, the side frame 22 is provided at a position that intersects the antenna pattern 41, when seen from the second direction D2 that is orthogonal to the first direction D1 and is parallel to the board surface described above. By employing an arrangement in which the antenna pattern 41 intersects with (in the present embodiment, is orthogonal to) the side frame 22 in this manner, it is possible to decrease the chance of the phenomenon where the amplitude of a current that arises in the antenna pattern 41 cancels out the amplitude of a current that arises in the side frame 22. In addition, the above-described arrangement can ensure gain (sensitivity) for both horizontal polarization and vertical polarization. As a result, it is possible to use the side frame 22 to effectively improve the antenna sensitivity of the antenna 40. In addition, the side frame 22, which is provided in a direction that intersects with the board surface of the circuit board 10 and the antenna pattern 41, effectively achieves an effect of stably securing the cover 31 and the support 32. Accordingly, it is possible to use the side frame 22 to improve antenna sensitivity while ensuring structural stability, impact resistance, and reliability for a product. In addition, the fact that the antenna pattern 41 and the side frame 22 may intersect when seen from the second direction leads to reducing design constraints. Accordingly, it is possible to improve antenna sensitivity while ensuring a degree of freedom for design.

In addition, the electronic timepiece 1 is provided with the cover 31 that covers at least a portion of the first surface 10a that is on the side opposite to the main frame 21 of the circuit board 10 and that has the engaging parts 311 that engage with the side frames 22. As a result, it is possible to use the frame 20 to secure the circuit board 10 via the cover 31, while using the cover 31 to protect the circuit board 10.

In addition, the frame 20 has the plurality of side frames 22 that are positioned on the side of the circuit board 10. One side frame 22 from among the plurality of side frames 22 is provided at a position that faces and intersects with the antenna pattern 41 when seen from the second direction D2. As a result, it is possible to cause one of the plurality of side frames 22 to function as an antenna.

In addition, the antenna pattern 41 is positioned in the periphery of the circuit board 10, and an electrical conductor is not provided between the antenna pattern 41 and the one side frame 22 from among the plurality of side frames 22. As a result, it is possible for the antenna pattern 41 to be near the side frame 22, and effectively, it is possible to increase an effect of improving antenna sensitivity using the side frame 22.

In addition, the one side frame 22 from among the plurality of side frames 22 is substantially rectangular. As a result, it is possible to effectively cause a linear portion that is included in the substantially rectangular side frame 22 to function as an antenna.

In addition, the cover 31 has the plurality of engaging parts 311 that are provided at substantially equal intervals along the outer periphery of the circuit board 10, and the frame 20 has the plurality of side frames 22 at positions corresponding to the plurality of engaging parts 311. As a result, it is possible to use the frame 20 that has the plurality of side frames 22 to stably secure the cover 31 and the support 32.

In addition, the openings 221 are respectively provided at the plurality of side frames 22, and the cover 31 has the plurality of engaging parts 311 that have a protruding shape and engage with the openings 221. As a result, it is possible to cause the side frames 22 to reliably engage with the engaging parts 311, and it is possible to reliably secure the cover 31 and the support 32.

In addition, the frame 20 has the connection frame 23 that extends from the main frame 21 toward the circuit board 10 and is electrically connected to the ground-contacting surface 11 that is provided on the circuit board 10. As a result, the side frame 22 can be electrically connected to the ground-contacting surface 11 via the main frame 21 and the connection frame 23.

In addition, the conductive path that is from the antenna 40 and reaches the tip P3 of the side frame 22 via the connection point P2 which is the position where the circuit board 10 and the connection frame 23 are connected, has a length that substantially corresponds to 1/4 of the wavelength of radio waves that are transmitted or received by the antenna 40. As a result, the side frame 22 suitably functions as an antenna, and it is possible to effectively improve the sensitivity of the antenna 40.

In addition, the electronic timepiece 1 includes the support 32 that supports substantially all of the second surface 10b of the circuit board 10 and is on the side opposite to the first surface 10a of the circuit board 10, and by the main frame 21 being in contact with the support 32 and the side frame 22 engaging with the engaging parts 311 of the cover 31, the frame 20 secures the cover 31 and the support 32 in a state where the cover 31 and the support 32 sandwich the circuit board 10 therebetween. As a result, it is possible to use the frame 20 to secure the housing 30, which includes the cover 31 and the support 32, while using the housing 30 to protect the circuit board 10.

In addition, the cover 31 has the protrusions 312 that extend in the -Z direction toward the support 32, and the support 32 has, at positions corresponding to the protrusions 312, the recesses 322 that fit with the protrusions 312. As a result, it is possible to prevent the cover 31 and the support 32 from deviating in the XY planar direction.

### (Other)

Note that the present disclosure is not limited to the embodiment described above, and various modifications are possible.

For example, in the embodiment described above, the side frame 22 and the antenna pattern 41 are orthogonal when seen from the second direction D2, but the present disclosure is no limited to this. The side frame 22 and the antenna pattern 41 may obliquely intersect when seen from the second direction D2.

In addition, as long as the side frame 22 satisfies the above-described arrangement condition (the condition that the sum of the first conductive path R1 and the second conductive path R2 is a length that substantially corresponds to λ/4), the side frame 22 and the antenna pattern 41 need not intersect when seen from the second direction D2. An effect of reinforcing the antenna sensitivity of the antenna 40 is achieved even if the side frame 22 is arranged in such a manner.

In addition, the method of wireless communication is not limited to Bluetooth. In a case of using another communication method, the length of a conductive path from the antenna 40 to the tip of the side frame 22 (the sum of the first conductive path R1 and the second conductive path R2) may be adjusted in accordance with the frequency of radio waves used in that communication method.

In addition, a case in which the entire frame 20 is made of metal that is electrically conductive was exemplified, but the present disclosure is not limited to this. It is sufficient if, of the frame 20, at least the side frame 22 that functions as an antenna and the conductive path from the tip P3 of this side frame 22 to the connection point P2 of the connection frame 23 are electrically conductive, and other portions may be an insulator such as a resin.

In addition, in the embodiment described above, description was given using an example in which the engaging parts 311 that have a protruding shape and are provided on the side surface of the cover 31 engage with the openings 221 provided in the side frames 22 of the frame 20, but aspects of engagement between the cover 31 and the side frames 22 are not limited to this. For example, an engaging part in a recess shape may be provided on the side surface of the cover 31 with a protrusion in a shape that engages with this engaging part being provided on a surface of the side frame 22 that faces the side surface of the cover 31 so that this protrusion engages with the engaging part in the recess shape of the cover 31.

In addition, in the above-described embodiment, description was given by assuming that the antenna pattern 41 is completely linear, but the antenna pattern 41 may be somewhat curved. For example, a corner of the antenna pattern 41 may be bent into an L shape and partially extends in a different direction. In addition, all of the antenna pattern 41 may be slightly curved (such as by less than or equal to approximately 30 degrees, for example) so as to face a certain direction on average. In this case, this direction can be regarded as the first direction D1.

In addition, in the embodiment described above, the antenna pattern 41 and the side frame 22 are provided in the 11 o'clock direction, but the present disclosure is not limited to this, and the antenna pattern 41 as well as the side frame 22 may be provided in a direction other than the 11 o'clock.

For example, the electronic timepiece 1 was given as an example of the electronic device, but the present disclosure is not limited to this. The electronic device may be a motion sensor terminal that measures a state of motion, or any wearable device that a user wears on their body, such as an activity meter. In addition, the electronic device may be a portable device such as a smartphone or a tablet terminal.

In addition, it goes without saying that changes can be made, as appropriate, to the detailed configuration and detailed operation of each component of the electronic timepiece 1 according to the embodiment described above, in a scope that does not deviate from the spirit of the present disclosure.

While some embodiments of the present disclosure are described, the scope of the present disclosure is not limited to the embodiments described above, and includes the scope of the invention set forth in the claims and the scope of their equivalents.

## Claims

1. An electronic device (1), comprising:
a flat plate-shaped circuit board (10);
an antenna (40) that is provided on the circuit board and has an antenna pattern (41) that extends in a first direction parallel to a board surface of the circuit board; and
a frame (20) at least a portion of which is electrically connected to the antenna via a ground-contacting surface (11) of the circuit board,
wherein the frame has a main frame (21) and a side frame (22),
wherein at least a portion of the main frame overlaps the circuit board when seen from a direction that is orthogonal to the board surface,
wherein the side frame is electrically conductive, is connected to the main frame, and extends in a direction that is substantially orthogonal to the board surface at a side of the circuit board,
wherein the electronic device is configured to perform at least one of transmission and reception of radio waves having a desired wavelength, using a composite antenna (A) that has the antenna and the side frame.

2. The electronic device according to claim 1, wherein
the side frame is provided at a position that intersects the antenna pattern, when seen from a second direction that is orthogonal to the first direction and is parallel to the board surface.

3. The electronic device according to claim 1 or 2, comprising
a cover (31) that covers at least a portion of a first surface that is on a side opposite to the main frame side of the circuit board, the cover having an engaging part (311) that engages with the side frame.

4. The electronic device according to claim 3, wherein
the side frame includes a plurality of side frames,
the frame has the plurality of side frames that is positioned on the side of the circuit board, and
one side frame from among the plurality side frames is provided at a position that faces and intersects with the antenna pattern, when seen from a second direction that is orthogonal to the first direction and is parallel to the board surface.

5. The electronic device according to claim 4, wherein
the antenna pattern is positioned at a periphery of the circuit board, and
an electrical conductor is not provided between the antenna pattern and the one side frame from among the plurality of side frames.

6. The electronic device according to claim 4 or 5, wherein
the one side frame from among the plurality of side frames is substantially rectangular.

7. The electronic device according to any one of claims 4 to 6, wherein
the engaging part includes a plurality of engaging parts,
the cover has the plurality of engaging parts that is provided at approximately equal intervals along an outer periphery of the circuit board, and
the frame has the plurality of side frames at positions corresponding to the plurality of engaging parts.

8. The electronic device according to claim 7, wherein
a cut-out or an opening (221) is provided in each of the plurality of side frames, and
the cover has the plurality of engaging parts that have protruding shapes and engage with the cutouts or the openings.

9. The electronic device according to any one of claims 1 to 8, wherein
the frame has a connection frame (23) that extends from the main frame toward the circuit board and is electrically connected to the ground-contacting surface that is provided on the circuit board.

10. The electronic device according to claim 9, wherein
a conductive path that is from the antenna and reaches a tip of the side frame via a position where the circuit board is connected to the connection frame has a length that substantially corresponds to 1/4 of a wavelength of radio waves that are transmitted or received by the antenna.

11. The electronic device according to any one of claims 3 to 8, further comprising:
a support (32) that supports substantially an entirety of a second surface of the circuit board on the side opposite to the first surface,
wherein, by the main frame being in contact with the support and the side frame engaging with the engaging part of the cover, the frame secures the cover and the support in a state where the cover and the support sandwich the circuit board between the cover and the circuit board.

12. The electronic device according to claim 11, wherein
one of the cover and the support has a protrusion (312) that extends towards the other of the cover and the support in a direction that is substantially orthogonal to the board surface, and
the other of the cover and the support has, at a position that corresponds to the protrusion, a recess (322) that fits with the protrusion.
